# EUROPÄISCHE PATENTSCHRIFT

(11) **EP 2 057 698 B1**
(45) Veröffentlichungstag und Bekanntmachung des Hinweises auf die Patenterteilung: **25.05.2011**
(21) Anmeldenummer: 07817741.7
(22) Anmeldetag: 23.10.2007
(51) Int. Cl.: H01L 41/107

(54) **PIEZOELEKTRISCHER TRANSFORMATOR**
PIEZOELECTRIC TRANSFORMER
TRANSFORMATEUR PIÉZOÉLECTRIQUE

(30) Priorität: 24.10.2006 DE 102006050110
(43) Veröffentlichungstag der Anmeldung: 13.05.2009
(73) Patentinhaber: Epcos AG, 81669 München (DE)
(72) Erfinder: FLORIAN, Heinz, 8524 Bad Gams (AT); KARTASHEV, Igor, 8530 Deutschlandsberg (AT); SCHMIDT-WINKEL, Patrick, 8524 Bad Gams (AT)
(74) Vertreter: Epping - Hermann - Fischer
(86) Internationale Anmeldenummer: PCT/DE2007/001907
(87) Internationale Veröffentlichungsnummer: WO 2008/049415

(56) Entgegenhaltungen:
- EP-A- 1 710 849
- JP-A- 9 051 131
- JP-A- 10 290 034
- JP-A- 2001 326 398
- JP-A- 2002 076 464

## Beschreibung

Jeweils ein piezoelektrischer Transformator ist aus den Druckschriften US 6,172,447 B1, JP 2002314160 A, JP 2003008097 A und US 6794796 B2 bekannt.

Aus JP 2002-076 464 ist ein piezoelektrischer Transformator gemäß dem Oberbegriff des Anspruchs 1 bekannt. Weitere piezoelektrische Transformatoren mit Innenelektroden, die mit außenliegenden Kontaktflächen leitend verbundenen sind, sind aus JP 10-290 034 und aus JP 2001-326 398 bekannt.

JP 09-051131 zeigt Außenelektroden eines piezoelektrischen Transformators, die sich jeweils über zwei aneinander angrenzende Außenflächen des Transformators erstrecken. EP 1710849 A2 zeigt einen piezoelektrischen Transformator mit Durchkontaktierungen, die mehrere Innenelektroden miteinander verbinden.

Eine zu lösende Aufgabe besteht darin, einen piezoelektrischen Transformator gemäß dem Oberbegriff des Anspruchs 1 dahingehend zu verbessern, dass er trotz gleichbleibend geringer Bauhöhe einen verringerten elektrischen Widerstand zwischen den Kontaktflächen und den Innenelektroden besitzt.

Diese Aufgabe wird durch den piezoelektrischen Transformator gemäß Anspruch 1 gelöst.

Es wird ein piezoelektrischer Transformator mit einem Körper angegeben, der zwei mechanisch miteinander verbundene Funktionsteile des Transformators umfasst. Unter einem ersten Funktionsteil versteht man z. B. einen Eingangsteil und unter einem zweiten Funktionsteil einen Ausgangsteil des Transformators.

Der piezoelektrische Transformator wird im Folgenden Piezotransformator genannt.

Die Funktionsteile weisen jeweils erste und zweite Innenelektroden auf, die im Körper angeordnet und senkrecht zur Hauptfläche des Körpers ausgerichtet sind. Die ersten Innenelektroden des jeweiligen Funktionsteils sind leitend miteinander und mit einer ersten Kontaktfläche verbunden, die auf einer Hauptfläche des Körpers angeordnet ist. Die zweiten Innenelektroden des jeweiligen Funktionsteils sind leitend miteinander und mit einer zweiten Kontaktfläche verbunden, die auf derselben Hauptfläche des Körpers angeordnet ist.

Der angegebene Piezotransformator kann mit einer geringen Bauhöhe, beispielsweise weniger als 1 mm, ausgeführt werden. Der Piezotransformator ist beispielsweise geeignet zur Integration in einem eingebauten Netzteil eines kompakten elektrischen Moduls.

Die Anordnung der Kontaktflächen auf einer Hauptfläche statt einer Seitenfläche ist besonders vorteilhaft, da die Hauptfläche größer ist. Besonders vorteilhaft ist die Anordnung der Kontaktflächen auf einer Hauptfläche, falls der Körper die Form einer dünnen Platte hat - beispielsweise wenn seine Dicke bei einer Breite ≥ 4 mm den Wert von 1 mm nicht übersteigt - denn in diesem Fall wäre das Befestigen von Anschlussdrähten an den Seitenflächen des Körpers sehr schwierig.

Ein flacher Piezotransformator hat den Vorteil, dass er in einer Vertiefung eines Trägersubstrats leicht versenkt werden kann. Das Trägersubstrat kann dabei ein Gehäuse für den Transformator bilden. Dies ist besonders vorteilhaft im Hinblick auf die zunehmende Miniaturisierung elektrischer Bauelemente, in denen der Piezotransformator eingesetzt wird.

Der angegebene Piezotransformator zeichnet sich durch eine hohe Zuverlässigkeit aus, da durch die Anordnung der Kontaktflächen auf einer flächenmäßig größeren Hauptfläche eine bessere Haftung der Kontaktflächen an der Oberfläche des Körpers erzielt werden kann.

Die auf der Hauptfläche angeordneten Kontaktflächen sind außerdem besonders leicht zugänglich, was die Befestigung von Anschlussdrähten an den Kontaktflächen erleichtert.

Bei dem erfindungsgemäßen Piezotransformator sind die ersten Innenelektroden des jeweiligen Funktionsteils an eine erste Sammelelektrode und die zweiten Innenelektroden an eine zweite Sammelelektrode angeschlossen. Die erste Sammelelektrode ist mit einer ersten Kontaktfläche und die zweite Sammelelektrode mit einer zweiten Kontaktfläche leitend verbunden. Die ersten Sammelelektroden sind auf einer ersten Seitenfläche und die zweiten Sammelelektroden auf einer zweiten Seitenfläche des Körpers angeordnet. Die erste und zweite Seitenfläche sind einander gegenüber liegende laterale Flächen des Körpers, die parallel zueinander sind.

Anstelle der ersten und zweiten Innenelektroden können erfindungsgemäß auch erste und zweite Durchkontaktierungen vorgesehen sein. Dabei sind die ersten Innenelektroden des jeweiligen Funktionsteils mittels einer ersten Durchkontaktierung und die zweiten Innenelektroden mittels einer zweiten Durchkontaktierung miteinander verbunden. Die Durchkontaktierungen sind im Inneren des Körpers angeordnet und parallel zu seinen Hauptflächen ausgerichtet. Die Durchkontaktierungen erstrecken sich vorzugsweise parallel zur Längsachse des Körpers.

Die jeweilige Sammelelektrode und die ihr zugeordnete Kontaktfläche bilden zusammen eine Leiterfläche.

Die Kontaktflächen sind alle zu ein und derselben Hauptfläche, beispielsweise zur Unterseite des Körpers herausgeführt und können SMD-fähige Kontakte des Transformators bilden. SMD steht für Surface Mounted Device. Die Kontaktflächen sind alternativ alle zur Oberseite des Körpers herausgeführt. Die Kontaktflächen können auch auf beiden Hauptflächen des Körpers angeordnet sein.

Die Kontaktflächen sind beispielsweise über Anschlussdrähte kontaktierbar.

Der Körper weist eine Längsachse auf, die parallel zu seinen Hauptflächen verläuft. Die Innenelektroden stehen senkrecht auf dieser Achse.

Erste und zweite Innenelektroden des jeweiligen Funktionsteils sind vorzugsweise abwechselnd angeordnet, so dass sie ineinander greifen. Erste und zweite Innenelektroden werden mit voneinander unterschiedlichen elektrischen Potentialen beaufschlagt.

Zweite Innenelektroden der beiden Funktionsteile sind in einer Variante leitend miteinander verbunden. Die Funktionsteile können alternativ galvanisch voneinander entkoppelt sein. Die erfindungsgemäß vorgesehen Hilfselektroden sind als Elektroden ausgebildet, die wie Innenelektroden der Funktionsteile im Körper angeordnet sind.

Die jeweilige erste Kontaktfläche ist - in Dickenrichtung des Körpers gesehen - vorzugsweise über mehrere aufeinander folgende erste Hilfselektroden kontaktiert. In einer vorteilhaften Variante ist die jeweilige zweite Kontaktfläche in entsprechender Weise über mehrere aufeinander folgende zweite Hilfselektroden kontaktiert.

An den Eingangsteil des Transformators wird eine Eingangsspannung angelegt. Dadurch wird im Körper eine Schwingung angeregt, die im Ausgangsteil ein Ausgangssignal hervorruft. Die Ausgangsspannung ist vorzugsweise größer als die Eingangsspannung. Die Ausgangsspannung kann aber auch, je nach Ausgestaltung des Piezotransformators, gleich groß oder kleiner sein als die Eingangsspannung. Der vorgegebene Transformationsfaktor kann durch den Abstand zwischen den unterschiedlich gepolten Innenelektroden des jeweiligen Funktionsteils eingestellt werden.

Im Körper sind mechanische Schwingungen entlang seiner Längsachse, d. h. senkrecht zu den Innenelektroden, anregbar. Die Hauptfläche des Körpers ist in Längsrichtung vorzugsweise in einen Mittelbereich und Randbereiche aufgeteilt, wobei die Randbereiche frei von Kontaktflächen sind.

Die in Längsrichtung gemessene Breite der jeweiligen Kontaktfläche ist vorzugsweise kleiner als die in dieser Richtung gemessene Länge der leitend mit ihr verbundenen Sammelelektrode. In diesem Fall sind einige der Innenelektroden, die leitend mit dieser Kontaktfläche verbunden sind, von dieser beabstandet.

Der Piezotransformator wird nun anhand von schematischen und nicht maßstabgetreuen Figuren erläutert. Es zeigen:
Figur 1A in perspektivischer Außenansicht einen erfindungsgemäßen Piezotransformator mit Sammelelektroden auf seiner Seitenfläche und Kontaktflächen auf seiner Hauptfläche;
Figur 1B den Piezotransformator gemäß der Figur 1A in einem Teilquerschnitt mit teilweiser Darstellung der innenliegenden Hilfselektroden;
Figur 1C einen Piezotransformator gemäß einer alternativen erfindungsgemäßen Ausführungsform, bei der die Innenelektroden mittels Durchkontaktierungen miteinander verbunden sind;
Figur 2 im Querschnitt einen Piezotransformator, der auf einem Träger montiert ist.

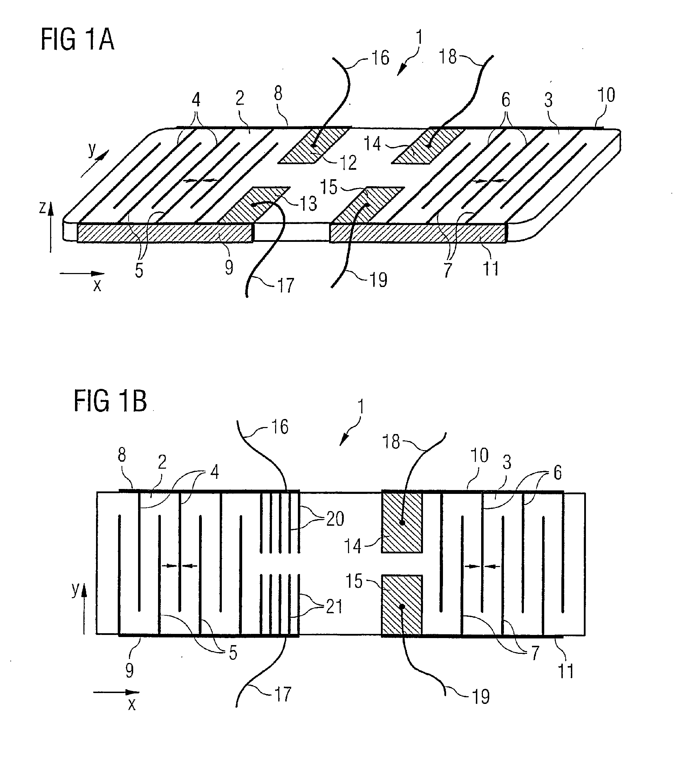

In den Figuren 1A, 1B ist ein Piezotransformator mit einem Körper 1 gezeigt, der einen Eingangsteil 2 und einen Ausgangsteil 3 umfasst. Die in Dickenrichtung des Körpers, d. h. z-Richtung gemessene Dicke bzw. Höhe des Körpers 1 ist in dieser Variante deutlich kleiner als seine in x-Richtung gemessene Länge oder in y-Richtung gemessene Breite. Der Körper hat in diesem Fall die Form einer Platte.

Der Eingangsteil 2 weist erste Innenelektroden 4 und zweite Innenelektroden 5 auf. Die ersten Innenelektroden 4 sind mittels einer ersten Sammelelektrode 8 leitend miteinander verbunden. Die zweiten Innenelektroden 5 sind mittels einer zweiten Sammelelektrode 9 leitend miteinander verbunden.

Der Ausgangsteil 3 weist erste Innenelektroden 6 und zweite Innenelektroden 7 auf. Die ersten Innenelektroden 6 sind mittels einer ersten Sammelelektrode 10 leitend miteinander verbunden. Die zweiten Innenelektroden 7 sind mittels einer zweiten Sammelelektrode 11 leitend miteinander verbunden. Die ersten und zweiten Innenelektroden des jeweiligen Funktionsteils bilden kammartige Elektrodenstapel, die ineinander greifen.

Die ersten Sammelelektroden 8, 10 sind an einer ersten Seitenfläche und die zweiten Sammelelektroden 9, 11 an einer zweiten Seitenfläche des Körpers angeordnet, die parallel zur ersten Seitenfläche ausgerichtet ist.

Die erste Sammelelektrode 8 des Eingangsteils ist leitend mit einer ersten Kontaktfläche 12 verbunden, die an der oberen Hauptfläche des Körpers 1 angeordnet ist. Die erste Sammelelektrode 10 des Ausgangsteils ist leitend mit einer ersten Kontaktfläche 14 verbunden. Die zweite Sammelelektrode 9 des Eingangsteils ist leitend mit einer zweiten Kontaktfläche 13 und die zweite Sammelelektrode 11 des Ausgangsteils mit einer zweiten Kontaktfläche 15 verbunden. Die Kontaktflächen 12, 13 bilden die Eingangsanschlüsse und die Kontaktfläche 14, 15 die Ausgangsanschlüsse des Transformators.

An der Kontaktfläche 12 ist ein Anschlussdraht 16, an der Kontaktfläche 13 ein Anschlussdraht 17, an der Kontaktfläche 14 ein Anschlussdraht 18 und an der Kontaktfläche 15 ein Anschlussdraht 19 befestigt. Die Anschlussdrähte verbinden den Piezotransformator elektrisch mit einem Träger - z. B. Leiterplatte oder Keramiksubstrat - bzw. einer in den Figuren nicht gezeigten externen elektrischen Schaltung, deren Komponenten auf dem Träger oder im Inneren des Trägers integriert sein können.

Die Innenelektroden 4, 5, 6, 7 sind in der in Fig. 1A, 1B gezeigten Ausführungsform mit den jeweiligen Kontaktflächen 12 bis 15 einerseits über außen liegende leitfähige Strukturen, d. h. die jeweiligen Sammelelektroden 8 bis 11, leitend verbunden.

Zur elektrischen Anbindung der jeweiligen ersten Kontaktfläche 12, 14 an die ersten Innenelektroden 4, 6 des jeweiligen Funktionsteils sind erste Hilfselektroden 20 vorgesehen. Zur elektrischen Anbindung der jeweiligen zweiten Kontaktfläche 13, 15 an die zweiten Innenelektroden 5, 7 des jeweiligen Funktionsteils sind zweite Hilfselektroden 21 vorgesehen. Die ersten Hilfselektroden 20 sind an die erste Sammelelektrode 8 angeschlossen und somit mit den ersten Innenelektroden 4 leitend verbunden. Die zweiten Hilfselektroden 21 sind an die zweite Sammelelektrode 9 angeschlossen und somit mit den zweiten Innenelektroden 5 leitend verbunden. Dies gilt gleichermaßen für beide Funktionsteile.

Die Hilfselektroden 20, 21 sind kürzer ausgebildet als die Innenelektroden 4, 5. Der Abstand zwischen den aufeinander folgenden ersten Hilfselektroden 20 ist vorzugsweise kleiner als der Abstand zwischen den aufeinander folgenden ersten und zweiten Innenelektroden 4, 5 des jeweiligen Funktionsteils. Der Abstand zwischen den Hilfselektroden kann auch gleich groß oder größer sein als derjenige zwischen den entgegengesetzt gepolten Innenelektroden. Dies gilt in entsprechender Weise auch für die zweiten Hilfselektroden 21.

Die leitend miteinander verbundenen Hilfselektroden 20 oder 21 bilden zusammen eine vorteilhafte Kontaktanordnung zur Kontaktierung der jeweiligen Kontaktfläche 12, 13, 14, 15. Diese Art der Kontaktierung ist besonders zuverlässig, da jede Kontaktfläche mehrfach kontaktiert wird. Die Kontaktierung der jeweiligen Kontaktfläche über eine Vielzahl von Hilfselektroden zeichnet sich durch einen niedrigen elektrischen Widerstand aus.

Die Kontaktierung der jeweiligen Kontaktfläche mittels nur einer Hilfselektrode ist im Prinzip auch möglich.

In der Figur 1B sind die Kontaktflächen 12, 13 zur Verdeutlichung dieser Anbindung entfernt worden. Die Kontaktierung zwischen dem jeweiligen Elektrodenstapel und der ihm zugeordneten Kontaktfläche wird nur für den Eingangsteil erläutert. Die Beschreibung gilt allerdings in entsprechender Weise auch für den Ausgangsteil.

Der Körper umfasst piezoelektrische Schichten, die vorzugsweise Keramik, beispielsweise Blei-Zirkonat-Titanat (PZT) enthalten. Andere piezoelektrische, insbesondere bleifreie, vorzugsweise keramische Materialien kommen auch in Betracht. Die Polarisationsrichtung der piezoelektrischen Schichten ist mit Pfeilen gekennzeichnet. Sie ist parallel zur Längsrichtung x. Die Schwingungen sind in diesem Fall durch einen relativ hohen elektromechanischen Koeffizienten k₃₃ charakterisiert.

Die jeweilige Innenelektrode 4, 5, 6, 7 bzw. Hilfselektrode 20, 21 ist zwischen zwei piezoelektrische Schichten angeordnet.

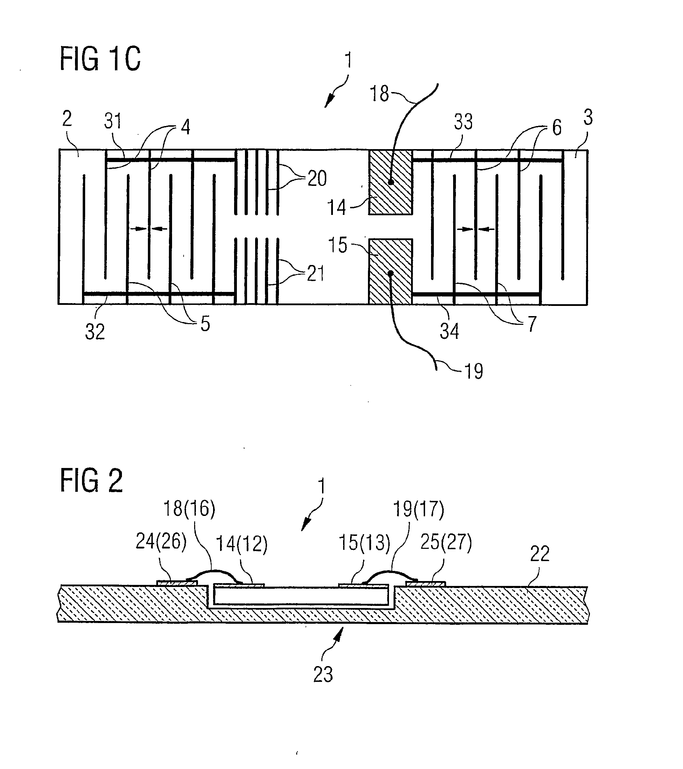

Figur 1C zeigt einen weiteren Piezotransformator. Die einander zugeordneten Innenelektroden sind in diesem Fall mittels jeweiligen Durchkontaktierungen 31 bis 34 leitend miteinander verbunden. Die Durchkontaktierungen sind im Körper 1 eingebettet. Die ersten Innenelektroden 4 des Eingangsteils 2 sind mittels einer ersten Durchkontaktierung 31 und die zweiten Innenelektroden 5 des Eingangsteils mittels einer zweiten Durchkontaktierung 32 untereinander verbunden. Die ersten Innenelektroden 6 des Ausgangsteils 3 sind mittels einer ersten Durchkontaktierung 33 und die zweiten Innenelektroden 5 des Ausgangsteils mittels einer zweiten Durchkontaktierung 34 untereinander verbunden. Die Anbindung der jeweiligen Innenelektroden zu der entsprechenden Kontaktfläche 12, 13, 14, 15 erfolgt in diesem Fall, wie bereits in Zusammenhang mit der vorhergehenden Variante erläutert, über die ersten Hilfselektroden 20 bzw. zweiten Hilfselektroden 21, die kürzer ausgebildet sind als die Innenelektroden.

In der Figur 2 ist ein elektrisches Bauelement mit einer Trägerplatte 22 gezeigt, in der eine Vertiefung 23 zur Aufnahme des Piezotransformators ausgebildet ist. Die Trägerplatte 22 ist in einer Variante eine Leiterplatte. Sie kann alternativ als ein LTCC-Substrat verfügbar sein. LTCC steht für Low Temperature Cofired Ceramics.

An der Oberseite der Trägerplatte 22 sind elektrische Kontakte 24, 25, 26, 27 angeordnet. Jeder Anschlussdraht 16, 17, 18, 19 ist mit einem der Kontakte 24, 25, 26, 27 fest verbunden.

Der Körper 1 ist vorzugsweise nur über die Anschlussdrähte 16 - 19 mit der Trägerplatte 22 verbunden. Der Körper 1 ist vorzugsweise mit dem Boden der Vertiefung 23 nicht fest verbunden. Der Körper 1 ist vorzugsweise von den Seitenwänden der Vertiefung 23 beabstandet, so dass er in dieser Vertiefung im Wesentlichen ungestört schwingen kann.

Der Piezotransformator kann auch in Befestigungsbereichen auf dem Boden der Vertiefung 23 befestigt sein. Die Befestigungsbereiche sind vorzugsweise im Wesentlichen auf Wellenknotenbereiche beschränkt. In Wellenknotenbereichen ist die Schwingungsamplitude des Körpers besonders klein.

Der Körper 1 ist in der Vertiefung 23 vollständig versenkt, so dass die Kontaktflächen 12, 13, 14, 15 des Transformators und die elektrischen Kontakte 24, 25 des Trägersubstrats praktisch in einer Ebene angeordnet sind. Möglich ist aber auch, den Körper in der Vertiefung nur teilweise zu versenken.

Die Vertiefung 23 kann im Prinzip durch eine Öffnung ersetzt werden.

Die Ausgestaltung des Piezotransformators ist auf die in den Figuren erläuterten Beispiele nicht beschränkt. Die Lage der Kontaktflächen auf der Hauptfläche und insbesondere deren Lage relativ zueinander kann im Prinzip beliebig sein.

### Bezugszeichenliste

1 Körper
2 Eingangsteil
3 Ausgangsteil
4 erste Innenelektroden des Eingangsteils
5 zweite Innenelektroden des Eingangsteils
6 erste Innenelektroden des Ausgangsteils
7 zweite Innenelektroden des Ausgangsteils
8, 9, 10, 11 Sammelelektroden
12, 13 Kontaktflächen des Eingangsteils
14, 15 Kontaktflächen des Ausgangsteils
16, 17, 18, 19 Anschlussdrähte
20 erste Hilfselektroden
21 zweite Hilfselektroden
22 Trägerplatte
23 Vertiefung
24, 25 elektrische Kontakte
31, 32, 33, 34 Durchkontaktierung
x Längsrichtung
y Breitenrichtung
z Dickenrichtung

## Patentansprüche

1. Piezoelektrischer Transformator
- mit einem Körper (1),
- wobei der Körper (1) zwei mechanisch miteinander verbundene Funktionsteile (2, 3) des Transformators umfasst, die jeweils erste und zweite Innenelektroden (4, 5, 6, 7) umfassen, die senkrecht zu einer Hauptfläche des Körpers (1) ausgerichtet sind,
- wobei die ersten Innenelektroden (4, 6) des jeweiligen Funktionsteils leitend miteinander und mit einer ersten Kontaktfläche (12, 14) verbunden sind,
- wobei die zweiten Innenelektroden (5, 7) des jeweiligen Funktionsteils leitend miteinander und mit einer zweiten Kontaktfläche (13, 15) verbunden sind,
- wobei die ersten Innenelektroden (4, 6) des jeweiligen Funktionsteils an eine jeweilige erste Sammelelektrode (8, 10) angeschlossen oder mittels einer ersten Durchkontaktierung (31, 33) miteinander verbunden sind und
- wobei die zweiten Innenelektroden (5, 7) des jeweiligen Funktionsteils an eine jeweilige zweite Sammelelektrode (9, 11) angeschlossen oder mittels einer zweiten Durchkontaktierung (32, 34) miteinander verbunden sind,
**dadurch gekennzeichnet,**
- **dass** die erste und die zweite Kontaktfläche des jeweiligen Funktionsteils auf der Hauptfläche des Körpers angeordnet sind,
- **dass** bei dem jeweiligen Funktionsteil (2, 3) mindestens eine auf die erste Kontaktfläche (12, 14) treffende erste Hilfselektrode (20) und mindestens eine auf die zweite Kontaktfläche (13, 15) treffende zweite Hilfselektrode (21) vorhanden ist, wobei die mindestens eine erste Hilfselektrode (20) leitend mit der ersten Sammelelektrode (8, 10) oder der ersten Durchkontaktierung (31, 33) verbunden ist und wobei die mindestens eine zweite Hilfselektrode (21) leitend mit der zweiten Sammelelektrode (9, 11) oder der zweiten Durchkontaktierung (32, 34) verbunden ist, und
- **dass** die Hilfselektroden (20, 21) in dem Körper (1) parallel zu den Innenelektroden (4, 5, 6, 7) verlaufend angeordnet sind.

2. Transformator nach Anspruch 1,
- wobei die ersten Innenelektroden (4, 6) des jeweiligen Funktionsteils an eine jeweilige erste Sammelelektrode (8, 10) und die zweiten Innenelektroden (5, 7) des jeweiligen Funktionsteils an eine jeweilige zweite Sammelelektrode (9, 11) angeschlossen sind,
- wobei die erste Sammelelektrode (8, 10) mit der ersten Kontaktfläche (12, 14) und die zweite Sammelelektrode (9, 11) mit der zweiten Kontaktfläche (13, 15) leitend verbunden ist,
- wobei die Sammelelektroden (8, 9, 10, 11) auf zwei einander gegenüber liegenden Seitenflächen des Körpers angeordnet sind.

3. Transformator nach Anspruch 1,
- wobei die Durchkontaktierungen (31, 32, 33, 34) im Körper (1) angeordnet und parallel zu seinen Hauptflächen ausgerichtet sind.

4. Transformator nach Anspruch 1 oder 2,
- wobei die jeweilige Sammelelektrode (8, 9, 10, 11) und die ihr zugeordnete Kontaktfläche (12, 13, 14, 15) eine gemeinsame Leiterfläche bilden.

5. Transformator nach einem der Ansprüche 1 bis 4,
- wobei mindestens eine erste Innenelektrode (4, 6) auf die erste Kontaktfläche (12, 14) trifft, und
- wobei mindestens eine zweite Innenelektrode (5, 7) auf die zweite Kontaktfläche (13, 15) trifft.

6. Transformator nach einem der Ansprüche 1 bis 5,
- wobei die jeweilige Kontaktfläche (12, 13, 14, 15) mittels einer Anordnung von mehreren Hilfselektroden (20, 21) kontaktiert wird.

7. Transformator nach einem der Ansprüche 1 bis 6,
- wobei im Körper (1) mechanische Schwingungen entlang seiner Längsachse anregbar sind,
- wobei die Hauptfläche in Längsrichtung in einen Mittelbereich und Randbereiche aufgeteilt ist, wobei die Randbereiche frei von Kontaktflächen (12, 13, 14, 15) sind.

8. Transformator nach einem der Ansprüche 1 bis 7,
- wobei die in Längsrichtung (x) gemessene Breite der jeweiligen Kontaktfläche (12, 13, 14, 15) kleiner ist als die in dieser Richtung gemessene Länge der ihr zugeordneten Sammelelektrode (8, 10, 11, 12).

## Claims

1. Piezoelectric transformer
- with a body (1),
- the body (1) comprising two functional parts (2, 3) of the transformer that are mechanically connected to one another and each comprise first and second inner electrodes (4, 5, 6, 7), which are aligned perpendicularly in relation to a main area of the body (1),
- the first inner electrodes (4, 6) of the respective functional part being connected in a conducting manner to one another and to a first contact area (12, 14),
- the second inner electrodes (5, 7) of the respective functional part being connected in a conducting manner to one another and to a second contact area (13, 15),
- the first inner electrodes (4, 6) of the respective functional part being connected to a respective first collecting electrode (8, 10) or being connected to one another by means of a first interfacial connection (31, 32) and
- the second inner electrodes (5, 7) of the respective functional part being connected to a respective second collecting electrode (9, 11) or being connected to one another by means of a second interfacial connection (32, 34),
**characterized**
- **in that** the first and second contact areas of the respective functional part are arranged on the main area of the body,
- **in that**, in the case of the respective functional part (2, 3), there is at least one first auxiliary electrode (20), impinging on the first contact area (12, 14), and at least one second auxiliary electrode (21), impinging on the second contact area (13, 15), the at least one first auxiliary electrode (20) being connected in a conducting manner to the first collecting electrode (8, 10) or the first interfacial connection (31, 32) and the at least one second auxiliary electrode (21) being connected in a conducting manner to the second collecting electrode (9, 11) or the second interfacial connection (32, 34), and
- **in that** the auxiliary electrodes (20, 21) are arranged in the body (1) such that they run parallel to the inner electrodes (4, 5, 6, 7).

2. Transformer according to Claim 1,
- the first inner electrodes (4, 6) of the respective functional part being connected to a respective first collecting electrode (8, 10) and the second inner electrodes (5, 7) of the respective functional part being connected to a respective second collecting electrode (9, 11),
- the first collecting electrode (8, 10) being connected in a conducting manner to the first contact area (12, 14) and the second collecting electrode (9, 11) being connected in a conducting manner to the second contact area (13, 15),
- the collecting electrodes (8, 9, 10, 11) being arranged on two side faces of the body that lie opposite each other.

3. Transformer according to Claim 1,
- the interfacial connections (31, 32, 33, 34) being arranged in the body (1) and aligned parallel to the main areas thereof.

4. Transformer according to Claim 1 or 2,
- the respective collecting electrode (8, 9, 10, 11) and the contact area (12, 13, 14, 15) assigned to it forming a common conductor area.

5. Transformer according to one of Claims 1 to 4,
- at least one first inner electrode (4, 6) impinging on the first contact area (12, 14), and
- at least one second inner electrode (5, 7) impinging on the second contact area (13, 15).

6. Transformer according to one of Claims 1 to 5,
- the respective contact area (12, 13, 14, 15) being contacted by means of an arrangement of multiple auxiliary electrodes (20, 21).

7. Transformer according to one of Claims 1 to 6,
- mechanical vibrations being inducible in the body (1) along the longitudinal axis thereof,
- the main area being divided in the longitudinal direction into a central region and peripheral regions, the peripheral regions being free from contact areas (12, 13, 14, 15).

8. Transformer according to one of Claims 1 to 7,
- the width of the respective contact area (12, 13, 14, 15), measured in the longitudinal direction (x), being less than the length of the collecting electrode (8, 10, 11, 12) assigned to it, measured in this direction.

## Revendications

1. Transformateur piézoélectrique présentant
- un corps (1),
- le corps (1) comprenant deux parties fonctionnelles (2, 3) du transformateur reliées mécaniquement l'une à l'autre et comprenant chacune des premières et des deuxièmes électrodes intérieures (4, 5, 6, 7) orientées perpendiculairement à une surface principale du corps (1),
- les premières électrodes intérieures (4, 6) de chaque partie fonctionnelle étant reliées l'une à l'autre de manière conductrice et à une première surface de contact (12, 14),
- les deuxièmes électrodes intérieures (5, 7) de chaque partie fonctionnelle étant reliées l'une à l'autre de manière conductrice et à une deuxième surface de contact (13, 15),
- les premières électrodes intérieures (4, 6) de chaque partie fonctionnelle étant raccordées à une première électrode collectrice (8, 10) respective ou étant reliées l'une à l'autre au moyen d'un premier passage de contact (31, 33) et
- les deuxièmes électrodes intérieures (5, 7) de chaque partie fonctionnelle étant raccordées à une deuxième électrode collectrice (9, 11) respective ou étant reliées l'une à l'autre au moyen d'un deuxième passage de contact (32, 34),
**caractérisé en ce que**
la première et la deuxième surface de contact de chaque partie fonctionnelle sont disposées sur la surface principale du corps,
**en ce qu'**au moins une première électrode auxiliaire (20) qui touche la première surface de contact (12, 14) et au moins une deuxième électrode auxiliaire (21) qui touche la deuxième surface de contact (13, 15) sont prévues pour chaque partie fonctionnelle (2, 3), la ou les premières électrodes auxiliaires (20) étant reliées de manière conductrice à la première électrode collectrice (8, 10) ou au premier passage de contact (31, 33),
**en ce que** la ou les deuxièmes électrodes auxiliaires (21) sont reliées de manière conductrice à la deuxième électrode collectrice (9, 11) ou au deuxième passage de contact (32, 34) et
**en ce que** les électrodes auxiliaires (20, 21) sont disposées dans le corps (1) de manière à s'étendre parallèlement aux électrodes intérieures (4, 5, 6, 7).

2. Transformateur selon la revendication 1, dans lequel les premières électrodes intérieures (4, 6) de chaque partie fonctionnelle sont raccordées à une première électrode collectrice (8, 10) respective et les deuxièmes électrodes intérieures (5, 7) de chaque partie fonctionnelle sont raccordées à une deuxième électrode collectrice (9, 11) respective,
la première électrode collectrice (8, 10) étant reliée de manière conductrice à la première surface de contact (12, 14) et la deuxième électrode collectrice (9, 11) à la deuxième surface de contact (13, 15),
les électrodes collectrices (8, 9, 10, 11) étant disposées sur deux surfaces latérales mutuellement opposées du corps.

3. Transformateur selon la revendication 1, dans lequel les passages de contact (31, 32, 33, 34) sont disposés dans le corps (1) et sont orientés parallèlement à ses surfaces principales.

4. Transformateur selon la revendication 1 ou 2, dans lequel chaque électrode collectrice (8, 9, 10, 11) et la surface de contact (12, 13, 14, 15) qui lui est associée forment une surface conductrice commune.

5. Transformateur selon l'une des revendications 1 à 4, dans lequel au moins une première électrode intérieure (4, 6) touche la première surface de contact (12, 14) et au moins une deuxième électrode intérieure (5, 7) touche la deuxième surface de contact (13, 15).

6. Transformateur selon l'une des revendications 1 à 5, dans lequel chaque surface de contact (12, 13, 14, 15) est mise en contact au moyen d'un système de plusieurs électrodes auxiliaires (20, 21).

7. Transformateur selon l'une des revendications 1 à 6, dans lequel des oscillations mécaniques peuvent être excitées le long de l'axe longitudinal du corps (1), la surface principale étant divisée dans le sens de la longueur en une partie centrale et en parties de bord, les parties de bord ne présentant pas de surfaces de contact (12, 13, 14, 15).

8. Transformateur selon l'une des revendications 1 à 7, dans lequel la largeur de chaque surface de contact (12, 13, 14, 15), mesurée dans le sens de la longueur (x), est plus petite que la longueur, mesurée dans cette direction, de l'électrode collectrice (8, 10, 11, 12) qui lui est associée.
